# EUROPÄISCHE PATENTANMELDUNG

(11) **EP 2 239 774 A1**
(43) Veröffentlichungstag der Anmeldung: **13.10.2010**
(21) Anmeldenummer: 10001493.5
(22) Anmeldetag: 13.02.2010
(51) Int. Cl.: H01L 23/29, H01L 23/31, H01L 29/06

(54) **Leistungshalbleiterbauelement mit einer Randpassivierung und Verfahren zu dessen Herstellung**

(30) Priorität: 11.04.2009 DE 102009017732
(71) Anmelder: SEMIKRON Elektronik GmbH & Co. KG, 90431 Nürnberg (DE)
(72) Erfinder: Fey, Tobias, 91058 Erlangen (DE); Berberich, Sven, 91080 Spardorf (DE); Stockmeier, Thomas, 91054 Erlangen (DE)

(57) **Zusammenfassung**

Die Erfindung beschreibt ein Leistungshalbleiterbauelement (10) mit einem Halbleiterkörper mit zwei sich gegenüberliegenden Hauptflächen, mit mindestens einer planaren (22a) oder einer MESA (22b) Randstruktur mit mindestens einer parallel zur und anschließend an die erste Hauptfläche (20) angeordneten ersten Zone (12) vom ersten Leitungstyp sowie einer daran anschließenden zweiten Zone (14) vom zweiten Leitungstyp. Hierbei ist die erste Hauptfläche (20) teilweise mit mindestens einem metallisierten Kontaktbereich (50) bedeckt und die Randstruktur (22a/b) auf oder neben der ersten Hauptfläche (20) des Halbleiterkörpers zumindest teilweise durch eine erste Passivierungsschicht (30) bedeckt. Diese erste Passivierungsschicht (30) besteht aus einem bis mindestens 200°C thermisch stabilen Isolierstoff der entweder ein präkeramisches Polymer oder ein Isozyanitharz oder ein Epoxydharz oder ein Plyetherketon ist. Weiterhin beschreibt die Erfindung ein zugehöriges Herstellungsverfahren.

## Beschreibung

### Beschreibung

Die Erfindung beschreibt ein Leistungshalbleiterbauelement mit einer planaren oder einer MESA Randstruktur, vorzugsweise als, allerdings nicht beschränkt auf, eine Diode oder einen Thyristor mit einer Sperrspannung von mehreren hundert bis über 2000V, und ein zugeordnetes Verfahren zur Herstellung eines derartigen Leistungshalbleiterbauelements. Diese Leistungshalbleiterbauelemente finden beispielhaft Anwendung in Stomrichterschaltungsanordnungen als Dioden oder Thyristoren für den ungesteuereten oder gesteuerten Eingangsgleichrichter zur Spannungsversorgung eines Zwischenkreises oder auch als Freilaufdioden zur Antiparallelschaltung mit Leistungstransistoren.

Die DE 40 13 435 A1 beschreibt Leistungshalbleiterbauelemente mit einer MESA Randstruktur sowie ein Passivierungsverfahren hierfür. Die hier vorgestellten Leistungshalbleiterbauelemente weisen eine MESA Randstruktur mit einem definierten von der gewünschten Sperrspannung abhängigen Winkel des Randbereiches auf. Es handelt sich bei dieser Passivierung um eine zweischichtige Ausgestaltung mit einer Passivierung aus Silikonkautschuk und einer zwischen diesem und der Oberfläche des Halbleiterkörpers angeordneten zusätzlichen dünnen Schicht bestehend aus amorphem Silizium.

Die Herstellung der Passivierungsschichten von Leistungsbauelementen mit einer MESA Randstruktur erfolgt dem Stand der Technik entsprechend an jedem Einzelchip als gesonderter Prozessschritt. Sie ist daher meist für runde, großflächige Leistungsbauelemente üblich, die eine Stromtragfähigkeit von mehreren hundert Ampere aufweisen. Solche Bauelemente finden meist Verwendung in elektrisch druckkontaktiert Aufbauvarianten, wobei die Leistungsbauelemente und damit auch deren Passivierung keinen Temperaturbeanspruchungen von mehr als 250°C ausgesetzt sind.

Leistungsbauelemente mit planarer Randstruktur, wie sie beispielhaft aus der DE 44 10 354 A1 bekannt sind werden im Waferverbund einer Vielzahl von Bauelementen hergestellt und die Randstrukturen auch im Waferverbund passiviert. Diese Leistungshalbleiterbauelemente mit planarer Randstruktur weisen im Vergleich zu denjenigen mit MESA Randstruktur meist eine geringere Größe und Stromtragfähigkeit auf, sind in der Regel rechteckig oder bevorzugt quadratisch ausgebildet, da dies für die Herstellung im Waferverbund eine wesentliche Vereinfachung darstellt.

Bei der Fertigung im Waferverbund erfolgt die Passivierung bevorzugt vor der Metallisierung, der Herstellung eines elektrisch leitenden Kontaktbereichs. Daher sollte die Passivierungsschicht stabil gegen einen bei der Metallisierung gebräuchlichen Temperprozess sein. Hierbei werden beispielhaft für lötfähig gestaltete Metallisierungen von Leistungsbauelementen gemäß des Standes der Technik die Leistungshalbleiterbauelemente mit Temperaturen von mindestens 360°C beaufschlagt. Daher offenbart die DE 44 10 354 A1 als anorganische Passivierungsschicht eine Glasschicht, die neben SiO₂ auch Metalloxide, vorzugsweise Bleioxid, enthält. Während der Herstellung dieser Glaspassivierung ist es allerdings erforderlich die Leistungshalbleiterbauelemente mit einer Temperatur von mehr als 800°C zu beaufschlagen. Somit kann dieser Prozessschritt nicht mehr nach der Metallisierung durchgeführt werden.

Weitere bekannte Verfahren zur Passivierung sind beispielhaft gemäß der DE 198 51 461 A1 verwenden Schichten aus amorphem, hydriertem Kohlenstoff (a-C:H), die durch Abscheidung aus einem Kohlenwasserstoff- Plasma erzeugt werden. Diese a-C:H-Schichten (amorphe hydrierte Kohlenstoffschicht in sp2 und sp3 Hybridisierung) weisen allerdings eine beschränkte Beständigkeit gegen Temperaturen von mehr als 300°C, sowie gegen Feuchtigkeit, auf. Aus letztgenanntem Grund ist es beispielhaft gemäß der DE 103 49 908 bekannt derartige a-C:H- Schicht mit einer weiteren Schicht zu bedecken.

Der vorliegenden Erfindung liegt die Aufgabe zu Grunde ein Leistungshalbleiterbauelement sowie ein Verfahren zu dessen Herstellung vorzustellen, wobei das Leistungsbauelement eine Randpassivierung einer planaren oder einer MESA Randstruktur aufweist, für hohe Sperrspannungen bis über 2000V geeignet ist und wobei die Passivierungsschicht selbst uneingeschränkt temperaturbeständig im Betrieb des Leistungshalbleiterbauelements ist und wobei das Herstellungsverfahren der Passivierungsschicht selbst keine Prozesstemperatur über 400°C erfordert.

Diese Aufgabe wird gelöst durch ein Leistungshalbleiterbauelement nach dem Anspruch 1 sowie durch ein Verfahren nach Anspruch 5, spezielle Ausgestaltungen finden sich in den abhängigen Ansprüchen.

Das erfindungsgemäße Leistungshalbleiterbauelement weist einen Halbleiterkörper mit zwei sich gegenüberliegenden Hauptflächen, auf. Im Randbereich des Leistungshalbleiterbauelement weist dieses mindestens eine planare oder eine MESA Randstruktur auf, die sich sowohl unmittelbar am Rand des Leistungshalbleiterbauelements oder geringfügig davon beabstandet befinden kann.

Weiterhin weist das Leistungshalbleiterbauelement mindestens eine parallel zur und anschließend an die ersten Hauptfläche angeordnete und sich in den Halbleiterkörper hinein erstreckende ersten Zone vom ersten Leitungstyp sowie eine daran anschließende zweiten Zone vom zweiten Leitungstyp auf.

Eine erste Hauptfläche ist teilweise mit mindestens einem metallisierten Kontaktbereich zur elektrischen Verbindung des Leistungshalbleiterbauelements bedeckt. Die Randstruktur auf oder neben der ersten Hauptfläche des Halbleiterkörpers ist zumindest teilweise durch eine erste Passivierungsschicht bedeckt, wobei diese erste Passivierungsschicht aus einem bis mindestens 200°C thermisch stabilen Isolierstoff besteht der entweder ein präkeramisches Polymer oder ein Isozyanitharz oder ein Epoxydharz oder ein Plyetherketon ist. Zudem kann es hier bevorzugt sein zumindest abschnittsweise zwischen der der ersten Passivierungsschicht und dem Halbleiterkörper noch eine zweite im Vergleich zur ersten dünnere Passivierungsschicht anzuordnen.

Es kann weiterhin bevorzugt sein, wenn dieser Isolierstoff mittels eines keramischen Pulvers mit einem Füllgrad zwischen 0,5 Vol% und 95 Vol% gefüllt ist. Eine vorteilhafte Größe der Korngröße dieses Pulvers liegt zwischen 0,5µm und 500µm. Als Material des keramischen Pulvers sind besonders geeignet die Stoffe der Gruppe Bornitrid (BN), Siliziumcarbid (SiC), Siliziumnitirt (Si₃N₄), Aluminiumnitrid (AIN), Steatit oder Codierit.

Das erfindungsgemäße Verfahren zur Herstellung eines o.g. Leistungshalbleiterbauelements besteht aus den folgenden wesentlichen Teilprozessen, wobei Prozessschritte nach dem Stand der Technik stark verkürzt angegeben oder weggelassen werden:
A) Ausbilden des Halbleiterkörpers mit den Zonen unterschiedlicher Leitungstypen im Waferverbund, wodurch die grundsätzliche Funktionalität des Leistungshalbleiterbauelements hergestellt wird.
B) Ausbilden der planaren oder der MESA Randstruktur. Falls sich die MESA Struktur im unmittelbaren Randbereich befindet kann es vorteilhaft sein vor dem eigentlichen Ausbilden der MESA Struktur den Waferverbund aufzulösen, also die Leistungshalbleiterbauelemente zu vereinzeln. Dieses Vereinzeln vor Ausbilden der MESA Struktur ist vor allem für großflächige runde Leistungshalbleiterbauelemente geeignet.
C) Anordnen der ersten Passivierungsschicht aus einem Isolierstoff, der entweder
   ein präkeramisches Polymer oder
   ein Isozyanitharz oder
   ein Epoxydharz oder
   ein Polyetherketon ist. Hierbei wird Bezug genommen auf die oben genannten Ausgestaltungen bezüglich der Art, Größe und Menge der Füllstoffe. Zudem kann es vorteilhaft sein vor Anordnung der ersten Passivierungsschicht die hiermit zu überdeckenden Bereiche noch zumindest teilweise mit einer zweiten dünneren Passivierungsschicht zu überdecken. Hierfür bieten sich aus dem Halbleitermaterial direkt erzeugte thermische Oxide an.

Im Übrigen wird noch vor Anordnung der ersten Passivierungsschicht oder nach Anordnung der ersten oder falls vorhanden beider Passivierungsschichten eine Metallschicht zur elektrischen Kontaktierung mindestens auf der ersten Hauptfläche des Leistungshalbleiterbauelements angeordnet. In der Regel wird erst nach Fertigstellung des gesamten Leistungshalbleiterbauelements der Waferverbund in einzelne Leistungshalbleiterbauelemente zerteilt wird.

Zur Anordnung der ersten Passivierungsschicht ist es bevorzugt dies mittels eines Jetventils oder mittels einer Nadeldispenseinrichtung oder mittels Siebdruck oder mittels Schablonendruck auszuführen. Ebenso kann es im Waferverbund bevorzugt sein die erste Passivierungsschicht mittels eines flächigen Beschichtungsverfahrens und anschließender Strukturierung auszuführen.

Die Erfindung wird anhand von Ausführungsbeispielen in Verbindung mit den Fig. 1 bis 4 näher erläutert.

Fig. 1 zeigt ein erstes erfindungsgemäßes Leistungshalbleiterbauelement mit planarer Struktur im Querschnitt.

Fig. 2 zeigt ein zweites erfindungsgemäßes Leistungshalbleiterbauelement mit planarer Struktur im Querschnitt.

Fig. 3 zeigt ein erstes erfindungsgemäßes Leistungshalbleiterbauelement mit MESA Struktur im Querschnitt.

Fig. 4 zeigt ein zweites erfindungsgemäßes Leistungshalbleiterbauelement mit MESA Struktur im Querschnitt.

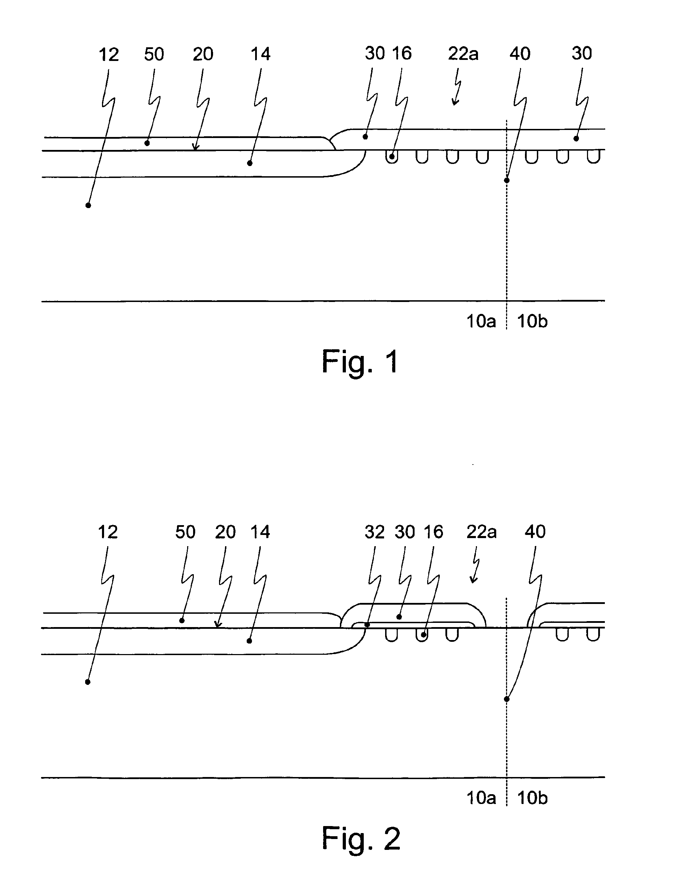

Fig. 1 zeigt schematisch ein erstes erfindungsgemäßes Leistungshalbleiterbauelement (10) mit planarer Struktur im Waferverbund. Dargestellt ist jeweils der Randbereich (22a) eines ersten (10a) und eines zweiten Leistungshalbleiterbauelements (10b) sowie die Linie (40) entlang derer nach allen Herstellungsschritten die Vereinzelung erfolgt. Der Halbleiterkörper des jeweiligen Leistungshalbleiterbauelements (10) weist einen Grundkörper erster Leitfähigkeit (12) sowie ein Dotierungsgebiet zweiter Leitfähigkeit (14) auf, wodurch ein pn- Übergang ausgebildet wird. Alternativ oder zusätzlich kann das Leistungshalbleiterbauelement (10) auch mittels Epitaxieverfahren hergestellte Gebiete aufweisen ohne dass hierdurch die Erfindung eingeschränkt wäre.

Als weitere Strukturen sind noch Potentialringe (16) zweiter Leitfähigkeit im Randbereich (22a) des Leistungshalbleiterbauelements (10) angedeutet. Diese Potentialringe (16) und der Bereich in dem der pn- Übergang, der Übergang von erster (12) zu zweiter Leitfähigkeit (14), die erste Hauptfläche des Leistungshalbleiterbauelements (10) erreicht sind mittels einer ersten Passivierungsschicht (30) bedeckt. Diese erste Passivierungsschicht (30) besteht aus einem bis mindestens 200°C thermisch stabilen Isolierstoff, der entweder als ein präkeramisches Polymer oder ein Isozyanitharz oder ein Epoxydharz oder ein Plyetherketon ausgebildet ist. Im Falle eines präkeramischen Poylmers ist es bevorzugt, wenn dieses ein Polysiloxan ist, im Fall des Polyetherketons ist es bevorzugt, wenn dieses ein Polyetheretherketon (PEEK) ist.

Diese erste Passivierungsschicht (30) erstreckt sich lateral vom Rand des Leistungshalbleiterbauelements (10a), der an der Linie (40) nach der Vereinzelung gebildet wird bis über die Außenbereiche des Dotierungsgebiet (14) zweiter Leitfähigkeit, um den pn- Übergangs, der hier die Oberfläche des Halbleiterkörpers erreicht ebenso wie die Potentialringe (16) zu überdecken. Eine Metallisierung (50) dient hier als elektrische Kontaktfläche des Leistungshalbleiterbauelements (10a) und bedeckt das Dotierungsgebiet (14) vollständig mit Ausnahme desjenigen Bereichs der durch die erst Passivierungsschicht (30) überdeckt ist.

Fig. 2 zeigt schematisch ein zweites erfindungsgemäßes Leistungshalbleiterbauelement (10) mit planarer Struktur im Waferverbund. Der Halbleiterkörper ist gleichartig demjenigen in Fig. 1 ausgebildet. Die erste Passivierungsschicht (30) überdeckt hierbei ebenfalls den pn- Übergang an der Hauptfläche (20) sowie die Potentialringe (16) nicht aber den Bereich (40) im dem die Vereinzelung der Leistungshalbleiterbauelemente (10 a/b) durchgeführt wird.

Zusätzlich zur ersten Passivierungsschicht (30), allerdings sich nicht über dessen gesamte Grundfläche erstreckend, ist zwischen dieser und dem Halbleiterkörper eine zweite Passivierungsschicht (32) angeordnet. Diese zweite Passivierungsschicht (32) ist dünner ausgestaltet als die erste Passivierungsschicht (30) und hier als thermisches Oxid ausgebildet. Eine Metallisierung (50) überdeckt den Bereich zweiter Leitfähigkeit (14) in den gemäß Fig. 1 beschriebenen Bereichen und bildet wiederum die elektrische Kontaktschicht.

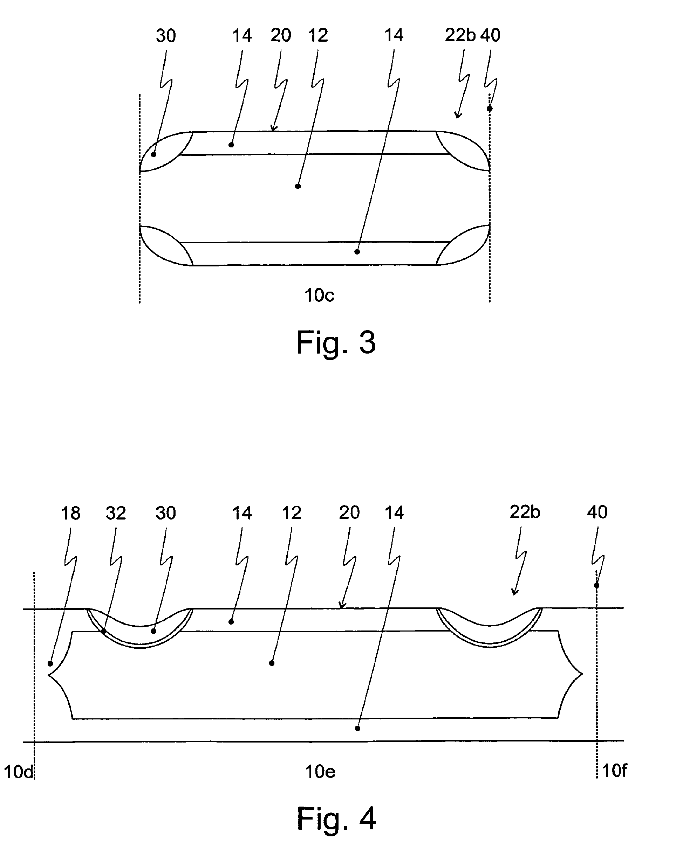

Fig. 3 zeigt schematisch ein erfindungsgemäßes Leistungshalbleiterbauelement (10c) in MESA Struktur nach der Vereinzelung an den Linien (40) aus dem Waferverbund. Dargestellt ist der Grundkörper erster Leitfähigkeit (12) sowie zwei Diffusionsgebiete zweiter Leitfähigkeit (14). Diese Ausgestaltung entspricht der grundlegenden, nicht vollständigen, Ausgestaltung eines Leistungsthyristors, da hier beispielsweise das Gebiet des Steueranschlusses wie auch die Metallkontakte nicht dargestellt sind. Die hier dargestellte MESA Struktur liegt im unmittelbaren Randbereich (22b) des Halbleiterkörpers, wodurch dieser sich zu seinem Rand hin verjüngt.

In diesem Bereich der Verjüngung ist die erste Passivierungsschicht (30) bestehend aus einem bis mindestens 200°C thermisch stabilen Isolierstoff, der entweder als ein präkeramisches Polymer oder ein Isozyanitharz oder ein Epoxydharz oder ein Plyetherketon ist angeordnet. Diese Schicht wird hier nach der Vereinzelung beispielhaft mittels bekannter Verfahren, beispielhaft mittels eines Jetventils, aufgebracht.

Fig. 4 zeigt schematisch ein erfindungsgemäßes Leistungshalbleiterbauelement (10e) mit einer MESA Struktur im Waferverbund zur Vereinzelung entlang der Linien (40). Hierbei sind die benachbarten Leistungshalbleiterbauelement (10d, 10f) nur angedeutet. Dargestellt ist der Grundkörper erster Leitfähigkeit (12) sowie zwei Diffusionsgebiete zweiter Leitfähigkeit (14). Das Gebiet zweiter Leitfähigkeit (14) an der ersten Hauptfläche ist mit dem Gebiet zweiter Leitfähigkeit (14) an der zweiten Hauptfläche mittels eines weiteren Gebiets zweiter Leitfähigkeit (18) verbunden. Diese Ausgestaltung entspricht der grundlegenden, nicht vollständigen, Ausgestaltung eines trenndiffundiereten Leistungsthyristors, dessen Anschlussflächen allesamt auf der ersten Hauptfläche (20) angeordnet sind.

Weiterhin ist im Randbereich (22b) das Gebiet zweiter Leitfähigkeit (14) auf der ersten Hauptfläche (20) durch zwei Gräben unterbrochen, die bis in das Gebiet erster Leitfähigkeit (12) hineinreichen und hierdurch die MESA Struktur begründen. In diesen Gräben liegt der Übergang erster (12) zu zweiter Leitfähigkeit (14) an der Oberfläche des Halbleiterkörpers und weist eine erste (30) und hier vorteilhafterweise auch eine zweite Passivierungsschicht (32) auf. Die erste Passivierungsschicht (30) ist aus einem bis mindestens 200°C thermisch stabilen Isolierstoff gebildet, der entweder als ein präkeramisches Polymer oder ein Isozyanitharz oder ein Epoxydharz oder ein Plyetherketon ausgestaltet ist.

Vorzugsweise wird die erste Passivierungsschicht (30) mittels Nadeldispenseinrichtung oder mittels Sieb- oder Schablonendruck angeordnet. Es kann allerdings ebenso vorteilhaft sein diese erste Passivierungsschicht (30) mittels eines flächigen Beschichtungsverfahrens und anschließender Strukturierung dieser Schicht anzuordnen

Die zweite Passivierungsschicht (32) ist hier vorzugsweise wiederum als thermisches Oxid ausgebildet und überdeckt den gleichen Bereich den auch die erste Passivierungsschicht (30) überdeckt, weist dieser gegenüber allerdings eine geringere mittlere Dicke auf.

## Patentansprüche

1. Leistungshalbleiterbauelement (10) mit einem Halbleiterkörper mit zwei sich gegenüberliegenden Hauptflächen, mit mindestens einer planaren (22a) oder einer MESA (22b) Randstruktur mit mindestens einer parallel zur und anschließend an die erste Hauptfläche (20) angeordneten ersten Zone (12) vom ersten Leitungstyp sowie einer daran anschließenden zweiten Zone (14) vom zweiten Leitungstyp, wobei die erste Hauptfläche (20) teilweise mit mindestens einem metallisierten Kontaktbereich (50) bedeckt ist und die Randstruktur (22 a/b) auf oder neben der ersten Hauptfläche (20) des Halbleiterkörpers zumindest teilweise durch eine erste Passivierungsschicht (30) bedeckt ist, wobei diese erste Passivierungsschicht (30) aus einem bis mindestens 200°C thermisch stabilen Isolierstoff besteht der entweder
ein präkeramisches Polymer oder
ein Isozyanitharz oder
ein Epoxydharz oder
ein Plyetherketon ist.

2. Leistungsbauelement nach Anspruch 1, wobei
der Isolierstoff mittels eines keramischen Pulvers mit einem Füllgrad zwischen 0,5 Vol% und 95 Vol% und einer Korngröße zwischen 0,5µm und 500µm gefüllt ist.

3. Leistungsbauelement nach Anspruch 3, wobei
das keramische Pulver aus der folgenden Gruppe ausgewählt ist: BN, SiC, Si₃N₄, AIN, Steatit, Codierit.

4. Leistungsbauelement nach Anspruch 1, wobei
zumindest abschnittsweise zwischen dem Halbleiterkörper und der ersten Passivierungsschicht (30) noch eine zweite im Vergleich dazu dünnere Passivierungsschicht (32) angeordnet ist.

5. Verfahren zur Herstellung eines Leistungshalbleiterbauelements (10) nach einem der vorhergehenden Ansprüche bestehend aus den wesentlichen Teilprozessen:
A) Ausbilden des Halbleiterkörpers mit den Zonen (12, 14) von unterschiedlichen Leitungstyp im Waferverbund.
B) Ausbilden der planaren (22a) oder der MESA (22b) Randstruktur;
C) Anordnen der ersten Passivierungsschicht (30) aus einem Isolierstoff, der entweder ein präkeramisches Polymer oder
ein Isozyanitharz oder
ein Epoxydharz oder
ein Polyetherketon ist.

6. Verfahren nach Anspruch 5, wobei
vor Anordnung der ersten Passivierungsschicht (30) der hiermit zu überdeckende Bereich noch zumindest teilweise mit einer zweiten dünneren Passivierungsschicht (32) bedeckt wird.

7. Verfahren nach Anspruch 5, wobei
der Waferverbund vor Erzeugung der MESA Randstruktur (22b) nach Schritt "A" in einzelne Leistungshalbleiterbauelemente (10c) zerteilt wird und die Passivierungsschicht (30) anschließend die MESA Randstruktur (22b) auf den vereinzelten Leistungshalbleiterbauelementen angeordnet wird.

8. Verfahren nach Anspruch 5, wobei
vor oder nach Anordnung der ersten Passivierungsschicht (30) eine Metallschicht (50) zur elektrischen Kontaktierung mindestens auf der ersten Hauptfläche (20) des Leistungshalbleiterbauelements (10) angeordnet wird und der Waferverbund nach diesen Schritten in einzelne Leistungshalbleiterbauelemente (10 a/b/d/e/f) zerteilt wird.

9. Verfahren nach Anspruch 8, wobei
die erste Passivierungsschicht (30) mittels eines Jetventils oder mittels einer Nadeldispenseinrichtung oder mittels Siebdruck oder mittels Schablonendruck angeordnet wird.

10. Verfahren nach Anspruch 8, wobei
die erste Passivierungsschicht (30) mittels eines flächigen Beschichtungsverfahrens und anschließender Strukturierung angeordnet wird.
